# EUROPÄISCHE PATENTANMELDUNG

(11) **EP 4 749 836 A1**
(43) Veröffentlichungstag der Anmeldung: **27.05.2026**
(21) Anmeldenummer: 25210726.3
(22) Anmeldetag: 23.10.2025
(51) Int. Cl.: H01R 12/71, H05K 1/02, H01R 12/57, F04D 13/06, H01R 27/00, H01R 29/00, H05K 1/11

(54) **VERFAHREN ZUR SCHAFFUNG EINER BUSTYPÜBERGREIFENDEN ELEKTRONIKPLATTFORM FÜR EINE STEUERELEKTRONIK EINES ELEKTRISCHEN ANTRIEBS EINER FLUIDPUMPE SOWIE EINE FLUIDPUMPE AUFWEISEND EINE SO GESCHAFFENE ELEKTRONIKPLATTFORM**

(30) Priorität: 12.11.2024 DE 102024133015
(71) Anmelder: NIDEC GPM GmbH, 98673 Auengrund /OT Merbelsrod (DE)
(72) Erfinder: Nickel, Conrad, 99438 Troistedt (DE); Herrling, Luis, 96524 Föritztal (DE); Weinert, Heidemarie, 98646 Reurieth OT Siegritz (DE)
(74) Vertreter: Kuhnen & Wacker Patent- und Rechtsanwaltsbüro PartG mbB

(57) **Zusammenfassung**

Die Erfindung betrifft ein Verfahren zur Schaffung einer bustypübergreifenden Elektronikplattform für eine Steuerelektronik (1) eines elektrischen Antriebs, insbesondere einer Fluidpumpe, wobei die Steuerelektronik (1) für eine Mehrzahl von Varianten der Fluidpumpe eine Steuerelektronikplatine (2) mit einem einheitlichen, insbesondere variantenübergreifend einheitlichen Platinenlayout (3) besitzt und das Platinenlayout (3) ein Anschlusspinmuster (4) mit einer Mehrzahl von Anschlusskontakteinrichtungen (5) besitzt, die Fluidpumpe ein Steckermodul (6) als Schnittstelle von dem Anschlusspinmuster (4) der Steuerelektronik (1) zu einem Pinmuster eines kundenseitigen Bordnetzes besitzt aufweisend die Schritte:
- Bereitstellen sämtlicher notwendiger Anschlusskontakteinrichtungen (5) für alle abzudeckenden Bustypen im Anschlusspinmuster (4) des Platinenlayouts (3);
- Anordnen von Eingangspins (8) des Steckermoduls (6) in einem Eingangspinmuster (9) korrespondierend zu einem Anschlusspinmuster (5) der Steuerelektronikplatine (2), insbesondere korrespondierend zu einem zu kontaktierenden Bustyp;
- Anordnen von Ausgangspins (10) in einem Ausgangspinmuster (11) des Steckermoduls (6) korrespondierend zu dem Pinmuster eines Gegensteckermoduls des kundenseitigen Bordnetzes;
- Überführen des Eingangspinmusters (9) des Steckermoduls (6) in das Ausgangspinmuster (11) des Steckermoduls (6) innerhalb eines Steckermodulgehäuses (13), wobei mehrere Leiterabschnitte (14), die je einendig einen Eingangspin (8) des Steckermoduls (6) bilden und anderendig einen Ausgangspin (10) des Steckermoduls (6) bilden, als Stanzbiegeteile ausgebildet werden, und die Leiterabschnitte (14) wenigstens in einem Bereich zwischen den Eingangspins (8) und den Ausgangspins (10) ein Leiterabschnittbündel (14) bildend umspritzt oder umgossen werden. (Fig.1)

## Beschreibung

Die Erfindung betrifft ein Verfahren zur Schaffung einer bustypübergreifenden Elektronikplattform für eine Steuerelektronik eines elektrischen Antriebs einer Fluidpumpe sowie eine Fluidpumpe aufweisend eine so geschaffene Elektronikplattform.

Aus der Sicht eines Zulieferers ist es gegenwärtig gängige Praxis, bei der Entwicklung von Fluidpumpen, insbesondere bei der Entwicklung von elektrischen Antrieben von Fluidpumpen ausgehend von individuellen, kundenspezifischen Anforderungen z.B. eines OEM-Kunden, eine Fluidpumpe zu entwickeln, die sämtlichen Anforderungen der Kundenseite entspricht. Bei beispielsweise elektrischen Fluidpumpen kann es vorkommen, dass von Seiten des Auftraggebers/Kunden unterschiedliche Datenübertragungsbussysteme verwendet werden oder zum Beispiel Pumpen mit unterschiedlichen Leistungsstufen angefordert werden. Je nach diesbezüglichen Anforderungen werden gemäß gegenwärtiger Praxis kundenspezifische Steuerelektroniken entwickelt, welche zum Lastenheft der Kundenanforderungen passen. Elektrische Fluidpumpen haben als ein Gehäuseteil meistens einen Abschlussdeckel, in welchen eine kundenspezifische Anschlussteckergeometrie integriert ist, die zum geeigneten elektrischen Anschluss an eine Buchse eines kundenspezifischen Kabelbaums ausgebildet ist. Unter anderem unterscheiden sich Stecker-Buchsen-Systeme unterschiedlicher Kunden auch in der Anzahl und oder Anordnung von Kontaktpins innerhalb eines Steckers. Um den Anforderungen eines jeden Kunden gerecht zu werden, werden derzeit Pinbelegungen durch entsprechende Anordnung auf einer Steuerelektronik-Platine und einer kundenspezifischen Steckerlösung im Abschlussdeckel verwirklicht.

Eine derartige Praxis hat sich zwar bewährt, um kundenindividuellen Anforderungen zu genügen. Nachteilig ist jedoch ein relativ hoher Konstruktionsaufwand betreffend die unterschiedliche Steuerelektronik, die unterschiedlichen Ausgestaltungen der Abschlussdeckel zusammen mit integrierten Kontaktpins und dergleichen. Des Weiteren entsteht hierdurch eine sehr hohe Variantenvielfalt unterschiedlicher Pumpen, deren Lagerhaltung und deren logistische Betreuung aufwendig ist.

Aufgabe der Erfindung ist es daher, eine Elektronikplattform mit geeignetem Steckerkonzept bereitzustellen, um mit möglichst wenigen Schnittstellen, insbesondere pumpenintern, möglichst viele Kundenschnittstellen/-Anforderungen verschiedener OEM-Hersteller abzudecken. Ziel ist außerdem, eine deutliche Verringerung einer Variantenvielfalt bei trotzdem gleichbleibend hoher Anpassbarkeit an spezifische Kundenanforderungen zu erreichen.

Diese Aufgaben werden in Bezug auf das Verfahren mit einen Verfahren zur Schaffung einer bustypübergreifenden Elektronikplattform für eine Steuerelektronik eines elektrischen Antriebs, insbesondere einer Fluidpumpe gelöst, wobei die Steuerelektronik für eine Mehrzahl von Varianten der Fluidpumpe eine Steuerelektronikplatine mit einem einheitlichen, insbesondere variantenübergreifend einheitlichen Platinenlayout besitzt und das Platinenlayout ein Anschlusspinmuster mit einer Mehrzahl von Anschlusskontakteinrichtungen besitzt und wobei die Fluidpumpe ein Steckermodul als Schnittstelle von dem Anschlusspinmuster der Steuerelektronik zu einem Pinmuster eines kundenseitigen Bordnetzes besitzt, aufweisend die Schritte:
- Bereitstellen sämtlicher notwendiger Anschlusskontakteinrichtungen für alle abzudeckenden Bustypen im Anschlusspinmuster des Platinenlayouts;
- Anordnen von Eingangspins des Steckermoduls in einem Eingangspinmuster korrespondierend zu dem Anschlusspinmuster der Steuerelektronikplatine, insbesondere korrespondierend zu dem zu kontaktierenden Bustyp;
- Anordnen von Ausgangspins in einem Ausgangspinmuster des Steckermoduls korrespondierend zu dem Pinmuster eines Gegensteckermoduls des kundenseitigen Bordnetzes;
- Überführen des Eingangspinmusters des Steckermoduls in das Ausgangspinmuster des Steckermoduls innerhalb eines Steckermodulgehäuses, wobei mehrere Leiterabschnitte, die je einendig einen Eingangspin des Steckermoduls bilden und anderendig einen Ausgangspin des Steckermoduls bilden, als Stanzbiegeteile ausgebildet werden, und die Leiterabschnitte wenigstens in einem Bereich zwischen den Eingangspins und den Ausgangspins ein Leiterabschnittbündel bildend umspritzt oder umgossen werden.

Das Umspritzen der Leiterabschnitte zur Bildung eines Leiterabschnittbündels erfolgt z.B. mittels Kunststoff, insbesondere einem Thermoplast unter Anwendung eines Kunststoffspritzgießverfahrens. Gleichwohl kann auch ein ein- oder mehrkomponentiger Duroplast zu Einsatz kommen. Die Bündelung durch Umspritzen oder Umgießen kann in einer geeigneten Gießform, in die die Leiterabschnitte eingelegt werden, erfolgen.

Bei einer bevorzugten Ausführungsform des Verfahrens wird das Leiterabschnittbündel als separates Bauteil ausgebildet und in das Steckermodulgehäuse eingesetzt.

Zweckmäßigerweise werden in einer Ausführungsform die Leiterabschnitte in einem Formwerkzeug für das Steckermodulgehäuse bei der Herstellung des Steckermodulgehäuses durch Umspritzen oder Umgießen gebündelt.

Zur busspezifischen Anpassung an ein kundenspezifisches Bordnetz, zum Beispiel eines bestimmten Fahrzeuges ist es zweckmäßig, dass mit dem Anschlusspinmuster des Platinenlayouts wenigstens ein Anschlusspinmuster für wenigstens einen nachfolgend aufgelisteten Bustyp bereitgestellt wird:
- Pulsweitenmodulation
- LIN-Bus (local interconnect network, Sensoren Aktuatoren), insbesondere in der Version 2.2 umfassend UDS (Unified Diagnostic Systems)
- CAN-Bus, insbesondere CAN-FD (CAN-Bus mit flexibler Datenrate)
- Flex-Ray-Bus (Recherche: geplante Bustypen e-Fahrzeuge)
- Ethernet

Zur Herstellung einer zuverlässigen, leicht und wirtschaftlich montierbaren Kontaktierung hat es sich bewährt, dass eine Kontaktierung der Eingangspins des Steckermoduls mit den jeweils korrespondierenden Anschlusskontakteinrichtungen des Anschlusspinmusters der Steuerelektronikplatine mittels press-fit-Pins, mittels Lötverbindungen und/oder mittels federbelasteter Kontaktelemente erfolgt.

Eine weitere Reduzierung eines individuellen Anpassungsaufwandes kann erreicht werden, wenn eine Anpassung einer Pinbelegung des Anschlusspinmusters an das kundenspezifische Bordnetz ausschließlich durch eine angepasste Leiterabschnittführung innerhalb des Steckermoduls erfolgt.

Vorteilhaft ist es, wenn an das Steckermodul unabhängig von kundenspezifischen Schnittstellengeometrien fluidpumpenseitig ein einheitlicher Steckerkragen zur Befestigung des Steckermoduls an einem variantenübergreifend einheitlichen Abschlussdeckel der Fluidpumpen angeformt wird.

Hierdurch gelingt es in besonderer Art und Weise, die Variantenvielfalt zu reduzieren und insbesondere kostenintensiv herzustellende Metallformteile der Fluidpumpen, zum Beispiel einen Abschlussdeckel, zu vereinheitlichen.

Hinsichtlich der Steuerungselektronik lässt sich die Variantenvielfalt in besonderem Maße reduzieren, wenn für die Steuerungselektronik ein Platinenlayout verwendet wird, welches mittels angepasster Bauteilbestückung an unterschiedliche kundenspezifische Anforderungen, zum Beispiel hinsichtlich einer Pumpenleistung, eines verwendeten Bussystems oder dergleichen, angepasst wird.

Eine solche Steuerungselektronik kann beispielsweise dadurch verwirklicht werden, dass ein einheitliches Bauteilbestückungsmuster, also ein sogenannter Footprint des Platinenlayouts, verwendet wird, wohingegen beispielsweise für ein bestimmtes Bauteil auf dem hierfür vorgesehenen Bestückungsplatz des Platinenlayouts unterschiedliche Bauteile, beispielsweise Kondensatoren unterschiedlicher Kapazität, Transistoren oder allgemein gesagt Halbleiterelemente mit unterschiedlicher Leistungsfähigkeit oder unterschiedlicher Wärmeabgabe angeordnet werden.

Zur weiteren Vereinfachung und zur Verminderung der Komplexität und der Variantenvielfalt, kann es außerdem zweckmäßig sein, dass an einem Antriebsgehäuse oder an dem Abschlussdeckel der Fluidpumpen eine für unterschiedliche Steckermodule, insbesondere für deren einheitliche Steckerkragen eine kundenanforderungsunabhängige einheitliche mechanische Aufnahmeschnittstelle bereitgestellt wird.

Eine solche Maßnahme macht die Fluidpumpen einheitlicher mechanischer Bauart für unterschiedlichste kundenspezifische Anforderungen einsetzbar, ohne dass Formteiländerungen an zum Beispiel mechanischen Bauteilen der Fluidpumpen, wie zum Beispiel Gehäusebauteilen, vorgenommen werden müssen.

Hinsichtlich der fluidpumpenspezifischen Aufgaben werden diese mit einer Fluidpumpe aufweisend eine bustypübergreifende Elektronikplattform für die Steuerelektronik, geschaffen nach dem erfindungsgemäßen Verfahren gelöst.

Im Folgenden wird die Erfindung anhand der Zeichnungen beispielhaft näher erläutert. Es zeigen:
- Figur 1:: einen Abschlussdeckel, eine Zwischenschicht und eine Steuerelektronik sowie ein kundenspezifisches Steckermodul für eine Fluidpumpe, welche nach dem erfindungsgemäßen Verfahren hergestellt wurde, in einer Explosionsdarstellung;
- Figur 2:: die Anordnung gemäß Figur 1 in einer isometrischen Ansicht im Zusammenbau;
- Figur 3 A:: eine Draufsicht auf eine erste Ausführungsform einer Steuerelektronikplatine mit 5 Anschlusskontakteinrichtungen;
- Figur 3 B:: eine isometrische Ansicht auf ein kundenspezifisches Steckermodul, welches pumpenseitig auf die Steuerelektronikplatine gemäß Figur 3 A abgestimmt ist;
- Figur 4 A:: eine Draufsicht auf eine zweite Ausführungsform einer Steuerelektronikplatine mit 4 Anschlusskontakteinrichtungen;
- Figur 4 B:: eine isometrische Ansicht auf ein kundenspezifisches Steckermodul, welches pumpenseitig auf die Steuerelektronikplatine gemäß Figur 4 A abgestimmt ist;
- Figur 5 A:: eine Draufsicht auf eine dritte Ausführungsform einer Steuerelektronikplatine mit 3 Anschlusskontakteinrichtungen;
- Figur 5 B:: eine isometrische Ansicht auf ein kundenspezifisches Steckermodul, welches pumpenseitig auf die Steuerelektronikplatine gemäß Figur 3 A abgestimmt ist;
- Figur 6:: eine isometrische Ansicht auf eine erste Ausführungsform eines Leiterabschnittsbündels aufweisend 3 eingangspinseitig versetzt angeordnete Eingangspins;
- Figur 7:: eine isometrische Ansicht auf eine zweite Ausführungsform eines Leiterabschnittsbündels aufweisend 3 eingangspinseitig in einer Reihe angeordnete Eingangspins;
- Figur 8:: ein Ablaufdiagramm betreffend das erfindungsgemäße Verfahren

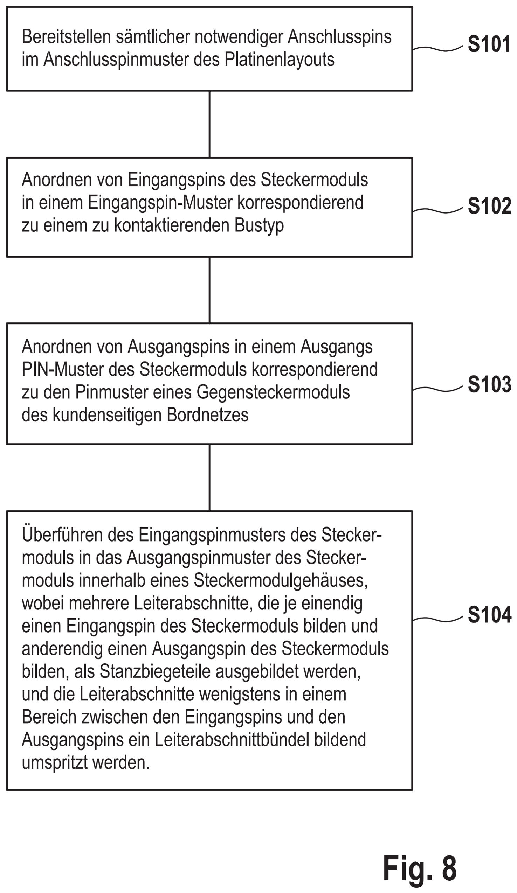

Das erfindungsgemäße Verfahren ist schematisch in Figur 8 im Rahmen eines Ablaufdiagrammes dargestellt und dient zur Schaffung einer bustypübergreifenden Elektronikplattform für eine Steuerelektronik 1 eines elektrischen Antriebs, insbesondere einer Fluidpumpe, wobei die Steuerelektronik für eine Mehrzahl von Varianten der Fluidpumpe eine Steuerelektronikplatine 2 mit einem einheitlichen Platinenlayout 3 besitzt und das Platinenlayout 3 ein Anschlusspinmuster 4 mit einer Mehrzahl von Anschlusskontakteinrichtungen 5 besitzt, wobei die Fluidpumpe ein Steckermodul 6 als Schnittstelle zu einem Pinmuster 7 eines kundenseitigen Bordnetzes besitzt.

Gemäß eines erfindungsgemäßen Verfahrens (Figur 8) wird zunächst in einem Schritt S 101 das Bereitstellen sämtlicher notwendiger Anschlusskontakteinrichtungen 5 in das Anschlusspinmuster 4 des Platinenlayouts 3 durchgeführt.

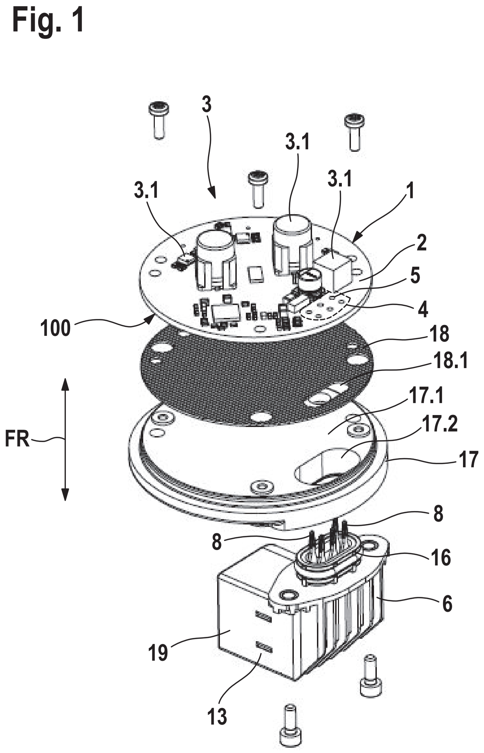

Hinsichtlich der Bezugszeichen für die Vorrichtungskomponenten wird insbesondere auf die Figuren 1 bis 7 verwiesen.

In einem Schritt S 102 werden Eingangspins 8 des Steckermoduls 6 in einem Eingangspinmuster 9 korrespondierend zu einem Anschlusspinmuster 5 der Steuerelektronikplatine 2, insbesondere korrespondierend zu einem zu kontaktierenden Bustyp angeordnet.

In einem Schritt S 103 werden Ausgangspins 10 in einem Ausgangspinmuster 11 des Steckermoduls 6 korrespondierend zu dem Pinmuster eines Gegensteckermoduls des kundenseitigen Bordnetzes angeordnet.

In einem Schritt S 104 wird das Eingangspinmuster 9 des Steckermoduls 6 in das Ausgangspinmuster 11 des Steckermoduls 6 innerhalb eines Steckermodulgehäuses 13 überführt, wobei mehrere Leiterabschnitte 14, die je einendig einen Eingangspin 8 des Steckermoduls 6 bilden und anderendig einen Ausgangspin 10 des Steckermoduls 6 bilden, als Stanzbiegeteile ausgebildet werden, und die Leiterabschnitte 14 wenigstens in einem Bereich zwischen den Eingangspins 8 und den Ausgangspins 10 ein Leiterabschnittbündel 15 bildend umspritzt oder umgossen werden.

Figur 1 zeigt einen Abschlussdeckel 17 für einen elektrischen Antrieb einer Fluidpumpe (nicht gezeigt). Der Abschlussdeckel 17 weist eine Innenseite 17.1 auf, die im verbauten Zustand des Abschlussdeckels 17 zu einem Motorinnenraum eines elektrischen Antriebs einer Fluidpumpe hin gerichtet ist. Gegen den Abschlussdeckel 17 ist eine isolierende Zwischenschicht 18 gesetzt.

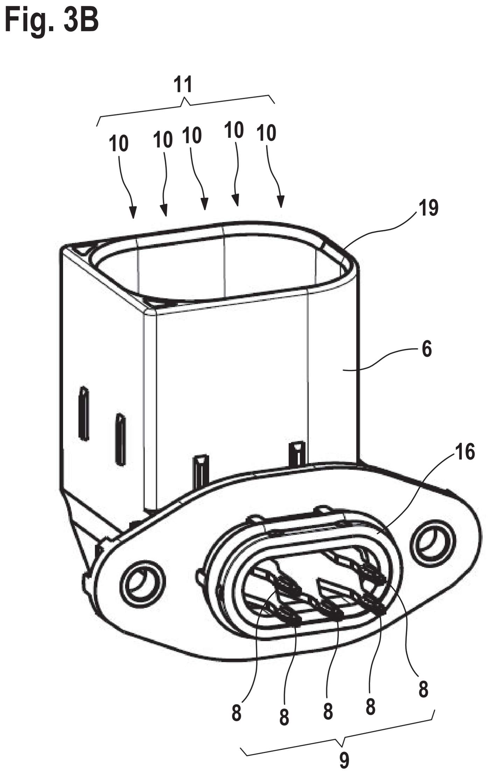

Vom Abschlussdeckel 17 aus betrachtet auf die isolierende Zwischenschicht 18 folgend ist die Steuerelektronik 1 mit der Steuerelektronikplatine 2 angeordnet. Die Steuerelektronikplatine 2 besitzt ein Platinenlayout 3, welches im Wesentlichen eine Anordnung von einzelnen Bauteilkomponenten 3.1, wie zum Beispiel Kondensatoren, Transistoren, Widerstände, integrierte Schaltkreise und/oder Spulen, aufweist. Das Platinenlayout 3 weist für die Bauteilkomponenten 3.1 für sämtliche abzudeckenden Varianten der Steuerelektronik 1 ein einheitliches Anordnungsmuster für die Bauteilkomponenten 3.1 sowie ein Anschlusspinmuster 4 auf, welches im vorliegenden Ausführungsbeispiel gemäß Figur 1 beispielsweise sechs Anschlusskontakteinrichtungen 5 aufweist, die zur Kontaktierung von Eingangspins 8 des Steckermoduls 6 (vergleiche Figur 3 B, 4 B, 5 B), welche ein spezifisches Eingangspinmuster 9 bilden, vorgesehen sind.

Der Abschlussdeckel 17 besitzt in einer Fügerichtung FR gesehen fluchtend zum Anschlusspinmuster 4 eine standardisierte Aufnahmeöffnung 17.2 zur Aufnahme eines standardisierten Steckerkragens 16 des Steckermoduls 6. Unter "standardisiert" ist im Zusammenhang dieser Erfindung zu verstehen, dass es sich um gleiche Geometrien über verschiedene Varianten der Fluidpumpen hinweg handelt. So ist zum Beispiel der Steckerkragen 16 variantenübergreifend geometrisch gleich korrespondierend zur geometrisch variantenübergreifend gleichen Aufnahmeöffnung 17.2 verschiedener Abschlussdeckel 17 ausgebildet, sodass der Abschlussdeckel 17 einheitlich über unterschiedliche Varianten der Fluidpumpen verwendet werden kann. Korrespondierend zur Aufnahmeöffnung 17.2 besitzt die Zwischenschicht 18 ebenfalls eine Öffnung 18.1.

Somit kann im Zusammenbau sichergestellt werden, dass die Eingangspins 8 des Steckermoduls 6 die Aufnahmeöffnung 17.2 und die Öffnung 18.1 durchgreifen können und die Anschlusskontakteinrichtungen 5 des Anschlusspinmusters 4 der Steuerelektronikplatine 2 von einer Unterseite 100 her kontaktieren können. Um dies zu bewerkstelligen, sind die Anschlusskontakteinrichtungen 5 über die Dicke der Steuerelektronikplatine 2 hindurch vorhanden und durchkontaktiert.

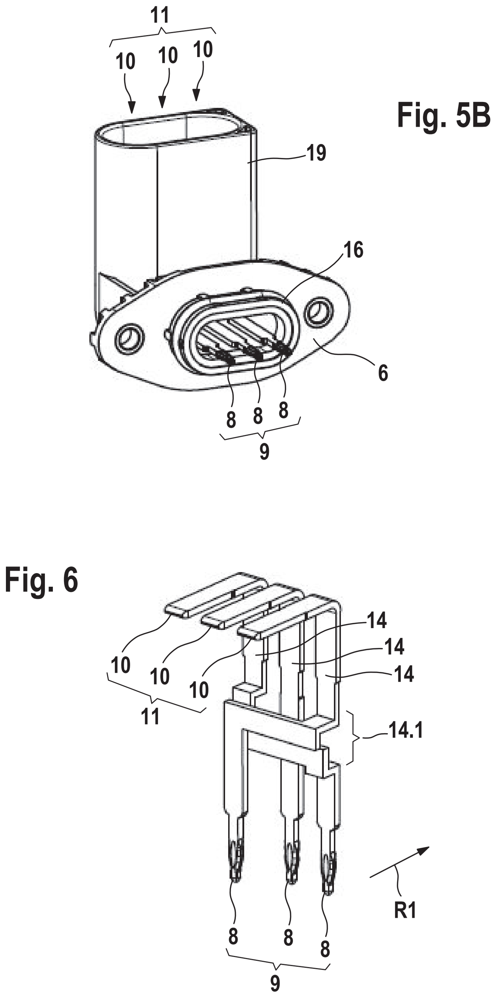

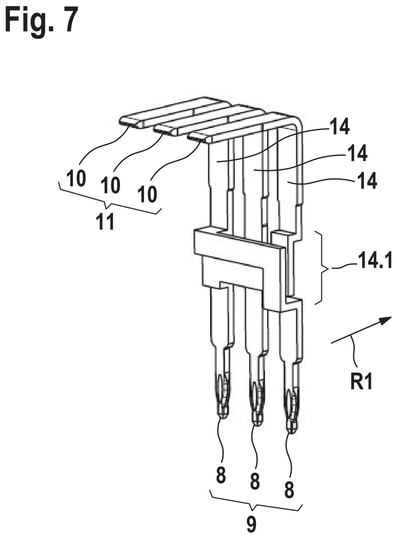

Das Steckermodul 6 ist hinsichtlich seiner Raumform im Wesentlichen durch das Steckermodulgehäuse 13 gebildet und besitzt eine Steckeraufnahme 19 zum Anschluss eines Gegensteckermoduls (nicht gezeigt), welches beispielsweise mit einem bordnetzseitigen Kabelbaum (nicht gezeigt) verbindbar ist. Innerhalb der Steckeraufnahme 19 sind die Ausgangspins 10 der Leiterabschnitte 14 im Ausgangspinmuster 11 angeordnet (vergleiche hierzu insbesondere Figur 6 und Figur 7).

In Figur 6 ist ein Beispiel von Leiterbahnabschnitten dargestellt, bei dem die Eingangspins 5 in der Richtung R1 versetzt zueinander angeordnet sind, wohingegen die Darstellung gem. Fig 7 ein Beispiel zeigt, bei dem die Eingangspins 5 aller drei dargestellten Eingangspins 5 in einer Reihe angeordnet sind. Diese Darstellungen sollen beispielhaft verdeutlichen, wie die Leiterabschnitte 14 eingangspinseitig zur Anpassung an das Anschlusspinmuster 4 angeordnet werden können. Ausgangspinseitig ist dies selbstverständlich durch geeignete Gestaltung der Leiterabschnitte 14 ebenfalls möglich.

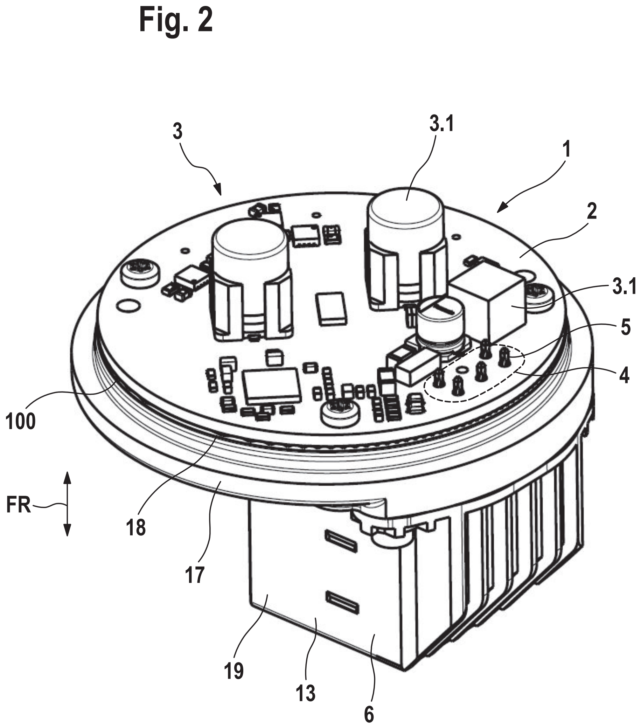

In Figur 2 ist der in Figur 1 in Explosionsdarstellung gezeigte Aufbau im montierten Zustand gezeigt.

In der Zusammenschau der Figuren 1 und 2 wird deutlich, dass für unterschiedliche Anschlussvarianten die Steuerelektronik 1 mit der Steuerelektronikplatine 2, sofern vorhanden, die Zwischenschicht 18 und der Abschlussdeckel 17 variantenübergreifend baugleich ausgebildet werden können. Das Steckermodul 6 besitzt den einheitlichen Steckerkragen 16 zum Einsetzen in die Aufnahmeöffnung 17. Eine kundenspezifische Individualisierung hinsichtlich eines kundenspezifischen Ausgangspinmusters 11 und hinsichtlich der geometrischen Raumform zumindest der Steckeraufnahmen 19 findet ausschließlich durch Anpassung des Steckermoduls 6 statt. Auch die geometrische Anordnung der Steckeraufnahme 19 kann kundenindividuell angepasst werden. So kann eine Steckrichtung senkrecht zur Fügerichtung FR oder in einem beliebigen Winkel zur Fügerichtung FR und eine rotatorisch um die Fügerichtung FR gesehen beliebige Anordnung der Steckeraufnahme 19 durch kundenspezifische individuelle Anpassung nur des Steckermodulgehäuses 13 bzw. des Steckermoduls 6 verwirklicht werden.

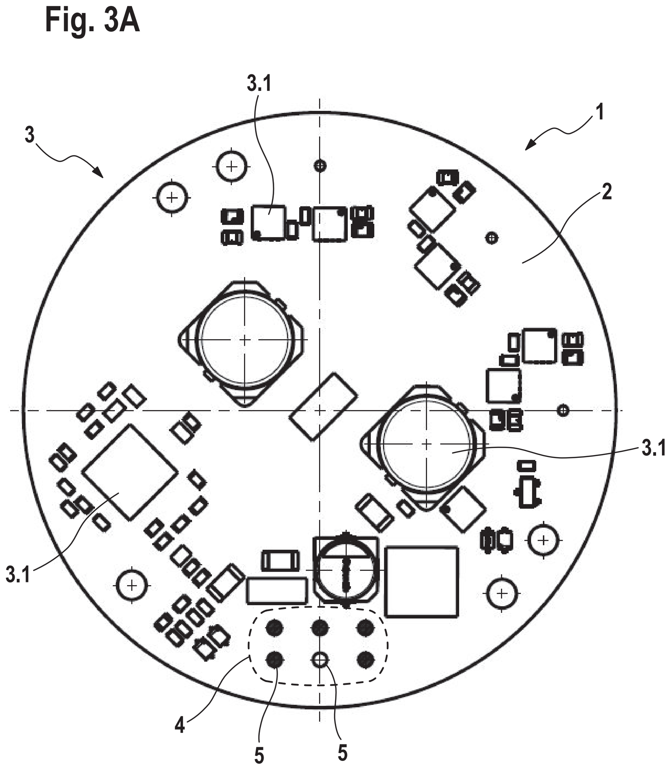

Anhand der nachfolgenden Beschreibung der Figuren 3 A, 4 A, 5 A werden insgesamt 3 unterschiedliche Varianten von kundenspezifischen Steuerelektroniken 1 beschrieben, welche sich lediglich im Anschlusspinmuster 5 unterscheiden. Alle 3 Varianten gemäß der Figuren 3 A, 3 B und 3 C haben das gleiche Platinenlayout 3 mit den identischen Anordnungspositionen der Bauteilkomponenten 3.1. Lediglich im Bereich des Anschlusspinmusters 4 unterscheiden sich die gezeigten Varianten wie folgt: die Anschlusspinmuster 5, welche in den Figuren 3 A, 3 B und 3 C als Vollpunkte dargestellt sind, repräsentieren die elektrisch belegten Anschlusskontakteinrichtungen 5, wohingegen eine kreisförmige Darstellung eines der Anschlusskontakteinrichtungen 5 einen elektrisch nicht belegten Anschlusspin 5 bezeichnet.

In der Ausführungsform gemäß Figur 3 A ist somit das Anschlusspinmuster 4 durch insgesamt fünf elektrisch belegte Anschlusskontakteinrichtungen 5 gebildet, welche zweireihig angeordnet sind, wobei ein mittlerer Anschlusspin 5 einer Reihe (in der Ansicht gemäß Figur 3 A der unteren Reihe) elektrisch nicht belegt ist.

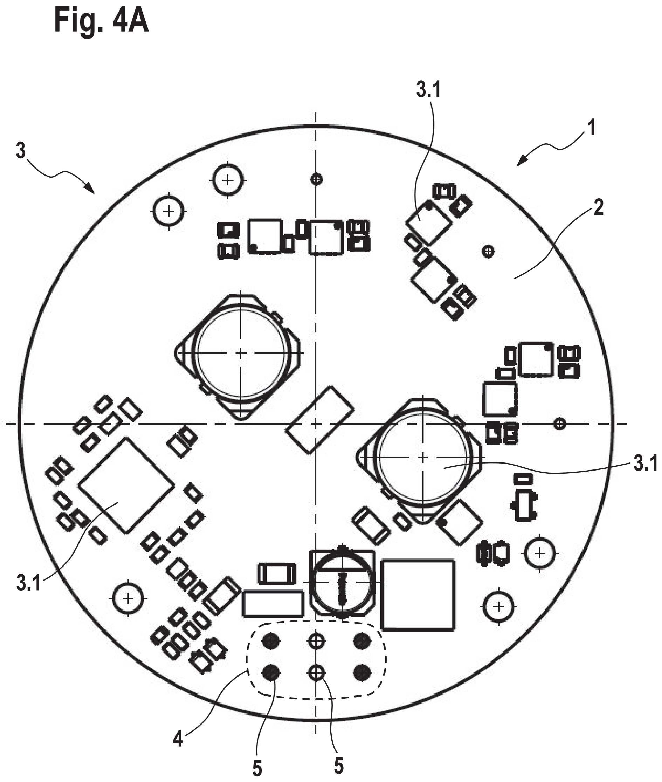

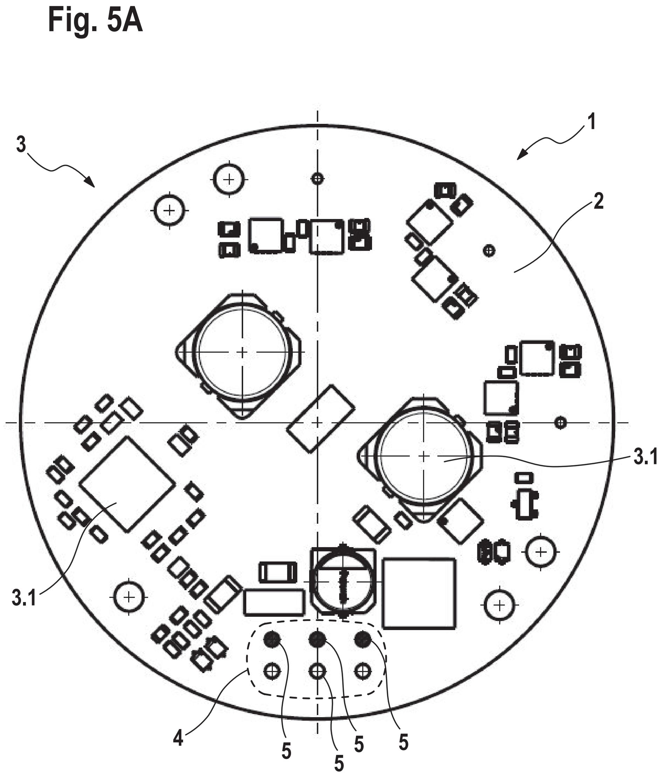

In der Ausführungsform gemäß der Figur 4 A sind lediglich 4 Anschlusskontakteinrichtungen 5 elektrisch belegt, wobei zwei Anschlusskontakteinrichtungen 5 elektrisch nicht belegt sind. In der Ausführungsform gemäß Figur 5 A sind drei Anschlusskontakteinrichtungen 5 elektrisch belegt, die drei weiteren Anschlusskontakteinrichtungen 5 sind elektrisch nicht belegt. In der Ausführungsform gemäß Figur 5 A sind alle elektrisch belegten Anschlusskontakteinrichtungen 5 in einer Reihe (in der Ansicht gemäß Figur 5 A die obere Reihe) angeordnet. Selbstverständlich können weitere beliebige Muster der Anschlusskontakteinrichtungen 5, welche beliebige Anschlusspinmuster 4 ergeben, verwirklicht werden. Wesentlich ist, dass zur Steuerelektronikplatine 2, unabhängig von der konkreten Ausgestaltung der Anschlusskontakteinrichtungen 5 und der des hieraus resultierenden Anschlusspinmusters 4, das Platinenlayout 3 gleich bleibt.

Zur Verwirklichung unterschiedlicher Anschlusspinmuster 4 sind beispielsweise einheitlich über alle Varianten der Steuerelektronikplatine 2 Steckplätze für Kontaktierungselemente, zum Beispiel Press-fit-Pins vorgesehen. Anstelle von Press-Fit-Pins können selbstverständlich auch freie Lötplätze oder federbelastete Kontaktelemente an den elektrisch belegten Anschlusskontakteinrichtungen 5 vorgesehen werden. Zur Realisierung zum Beispiel unterschiedlich leistungsfähiger Fluidpumpenmodule elektrischer Antriebe von Fluidpumpen kann es zweckmäßig sein, die Bauteilkomponenten 3.1 einer leistungsschwächeren Steuerelektronik 1 durch an gleicher Stelle des Platinenlayouts 3 angeordnete, den gleichen Bauteilgrundriss aufweisende leistungsfähigere Bauteilkomponenten 3.1 zu ersetzen. Somit kann mit ein und demselben Platinenlayout 3, d. h. mit einer einzigen Gestaltung der Steuerelektronikplatine 2 eine Vielzahl von Kontaktbelegungen wie auch durch Anpassung der Bestückungskomponenten 3.1 ein weites Leistungsspektrum der Steuerelektronik 1 abgedeckt werden.

Korrespondierend zu den beispielhaft im Rahmen der Figuren 3 A, 4 A und 5 A dargestellten Steuerelektronik 1 in unterschiedlichen Varianten zeigen die Figuren 3 B, 4 B und 5 B jeweils korrespondierende Steckermodule 6, welche den einheitlichen Steckerkragen 16 aufweisen.

Die Steckeraufnahme 19 ist hinsichtlich ihrer räumlichen Ausrichtung und hinsichtlich ihrer räumlichen Raumform an das nicht gezeigte Gegensteckermodul eines kundenspezifischen Kabelbaums angepasst. Innerhalb der Steckeraufnahmen 19 sind die Ausgangspins 10 angeordnet, welche das Ausgangspinmuster 11 bilden, welches zu den Kontaktbelegungen im kundenseitigen Gegensteckermodul (nicht gezeigt) passen.

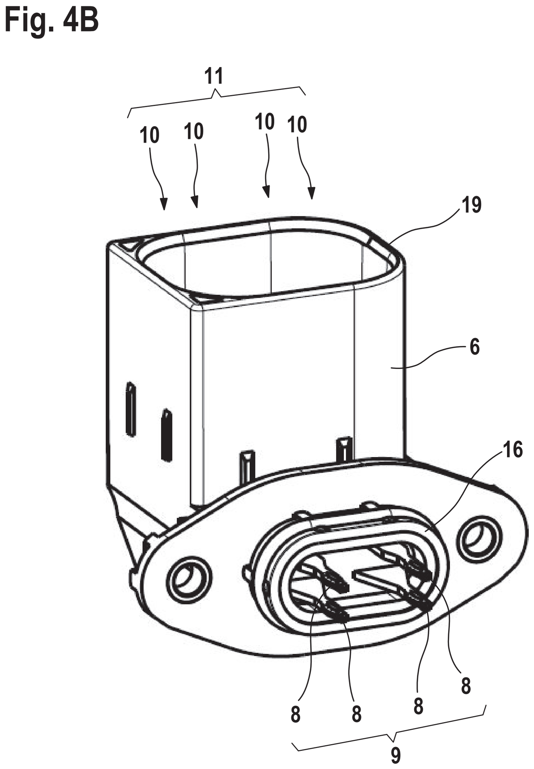

In der Darstellung gemäß Figur 3 B ist das fünf Eingangspins 8 aufweisende Eingangspinmuster 9 korrespondierend zum Anschlusspinmuster 4 der Steuerelektronikplatine 2 gemäß Figur 3 A gezeigt. In der Darstellung gemäß Figur 4 B ist das vier Eingangspins 8 aufweisende Eingangspinmuster 9 korrespondierend zum Anschlusspinmuster 4 der Steuerelektronikplatine 2 gemäß Figur 4 A gezeigt. In der Darstellung gemäß Figur 5 B ist das drei Eingangspins 8 aufweisende Eingangspinmuster 9 korrespondierend zum Anschlusspinmuster 4 der Steuerelektronikplatine 2 gemäß Figur 5 A gezeigt.

Um eine Anpassung des Eingangspinmusters 9 eines Steckermoduls 6, welches im Wesentlichen durch das Anschlusspinmuster 4 der Steuerelektronikplatine 2 vorgegeben wird, auf ein kundenspezifisches Ausgangspinmuster 11, gebildet durch die Ausgangspins 10, zu verwirklichen, wird erfindungsgemäß wie folgt vorgegangen. Die Eingangspins 8 und die Ausgangspins 10 sind jeweils durch einen Leiterabschnitt 14 miteinander verbunden. Jeder der Leiterabschnitte 14 ist erfindungsgemäß als metallisches Stanzbiegeteil ausgebildet und weist einendig je einen Eingangspin 8 und anderendig je einen Ausgangspin 10 auf. In einem Bereich zwischen den Eingangspins 8 und den Ausgangspins 10 sind Ausgleichsabschnitte 14.1 der Leiterbahnabschnitte 14 in einer ersten Richtung R 1 gestuft ausgebildet, sodass sie in unterschiedlichen, voneinander beabstandeten Ebenen aneinander vorbeigeführt werden können (vergleiche Figuren 6 und 7). Durch ein solches "aneinander vorbei führen" können unterschiedliche Pinanordnungen des Steuerelektronik-spezifischen Eingangspinmusters 9 gegenüber dem kundenspezifischen Ausgangspinmuster 11 verwirklicht werden. Selbstverständlich sind die "aneinander-vorbei-Führungen" elektrisch zueinander isoliert und beabstandet. Bevorzugt im Bereich der Ausgleichsabschnitte 14.1, in dem die Anpassung der Ausgangspinmuster 11 gegenüber den Eingangspinmustern 9 durch gegebenenfalls Überkreuzführung oder gestuft gestaffelte Führung der Leiterbahnabschnitte 14 erfolgt, findet erfindungsgemäß eine Bündelung mehrerer Leiterbahnabschnitte 14 statt, sodass ein Leiterabschnittsbündel 15 entsteht. Eine solche Bündelung kann beispielsweise durch wenigstens teilweises Umspritzen oder wenigstens teilweises Umgießen mit einem Kunststoff in einer Spritzgussform oder einer Gießform erfolgen. In bevorzugter Ausführungsform werden eine Mehrzahl von Leiterbahnenabschnitten 14 die ein gewünschtes Eingangspinmuster 9 in ein gewünschtes Ausgangspinmuster 11 überführen in ein Formwerkzeug für das Steckermodulgehäuse 13 eingelegt und z.B. beim Spritzgieß-Herstellungsprozess des Steckermodulgehäuses 13 durch den das Steckermodulgehäuse 13 bildenden Kunststoff gebündelt.

Im Ergebnis kann mit dem erfindungsgemäßen Verfahren somit eine erhebliche Reduzierung der Varianten von unterschiedlichen Steuerelektronikplatinen 2 erfolgen. Dies sowohl hinsichtlich ihrer körperlichen Ausgestaltung wie auch hinsichtlich ihrer leistungsmäßigen Abstimmung an unterschiedliche Pumpenleistungen, beispielsweise durch Bestückung mit unterschiedlichen Bauteilkomponenten 3.1 auf ein und demselben Platinenlayout 3.

Eine Anpassung des platinenlayoutspezifischen Anschlusspinmusters 4 an ein kundenspezifisches Ausgangspinmuster 11 erfolgt durch geeignete Führung der Leiterbahnenabschnitte 14 in den Ausgleichsabschnitt 14.1 und dem Bündeln/Umspritzen/Umgießen des Leiterabschnittbündels 15 bei der Herstellung des kundenspezifischen Steckermoduls 6. Im Ergebnis muss somit lediglich das Steckermodul 6 kundenspezifisch ausgeführt werden. Der Abschlussdeckel 17, die Zwischenschicht 18 sowie die Steuerelektronik 1, insbesondere deren Steuerelektronikplatine 2 bleibt variantenübergreifend unverändert.

Zur Verwirklichung der Kontaktierung unterschiedlicher Bussysteme, d. h. unterschiedlicher Datenübertragungssysteme, die je nach Kundenwunsch variieren können, ist es zweckmäßig, eine ausreichende Anzahl von Anschlusskontakteinrichtungen 5 im Anschlusspinmuster 4 vorzusehen, und je nach eingesetztem Datenbus nur eine Auswahl von Anschlusskontakteinrichtungen 5 des Anschlusspinmusters 4 elektrisch zu belegen, um einen bestimmten Datenbus-Typ, wie er typischerweise in Kraftfahrzeugen vorkommt, zu realisieren. Beispielhaft sind in den Figuren Varianten angedeutet, die 3, 4 oder 5 Anschlusskontakteinrichtungen benötigen. Eine derartig unterschiedliche Anzahl von Anschlusskontakteinrichtungen 5 lässt sich fachmännisch zu entsprechenden Datenbus-Typen zuordnen. Somit ist neben der leistungsmäßigen Anpassung einer nach der Erfindung hergestellten Steuerelektronik 1 durch variierende Bauteilbestückung ein und desselben Platinenlayouts 3 und der geometrischen Anpassung des Anschlusspinmusters 4 der Steuerplatine 2 an ein kundenspezifisches Ausgangspinmuster 11, welches im Steckermodul 6 realisiert ist, auch eine Datenbus-Anpassung an verschiedene Datenbus-Typen möglich, in dem das Anschlusspinmuster 4 je nach elektrischer Belegung der Anschlusskontakteinrichtungen 5 unterschiedliche Bustypen repräsentiert.

### Bezugszeichenliste

- 1: Steuerelektronik
- 2: Steuerelektronikplatine
- 3: Platinen Layout
- 3.1: Bauteilkomponenten
- 4: Anschlusspinmuster
- 5: Anschlusskontakteinrichtungen
- 6: Steckermodul
- 7 8: Eingangs Pin
- 9: Eingangspinmuster
- 10: Ausgangspin
- 11: Ausgangspinmuster
- 12 13: Steckermodul Gehäuse
- 14: Leiterabschnitte
- 14.1: Ausgleichsabschnitte
- 15: Leiterabschnittbündel
- 16: Steckerkragen
- 17: Abschlussdeckel
- 17.1: Innenseite
- 17.2: Aufnahmeöffnung
- 18: Zwischenschicht
- 18.1: Öffnung
- 19: Steckeraufnahme
- S 101 bis S 104: Schritte
- F R: Fügerichtung
- R1: erste Richtung

## Patentansprüche

1. Verfahren zur Schaffung einer bustypübergreifenden Elektronikplattform für eine Steuerelektronik (1) eines elektrischen Antriebs, insbesondere einer Fluidpumpe, wobei die Steuerelektronik (1) für eine Mehrzahl von Varianten der Fluidpumpe eine Steuerelektronikplatine (2) mit einem einheitlichen, insbesondere variantenübergreifend einheitlichen Platinenlayout (3) besitzt und das Platinenlayout (3) ein Anschlusspinmuster (4) mit einer Mehrzahl von Anschlusskontakteinrichtungen (5) besitzt, und wobei die Fluidpumpe ein Steckermodul (6) als Schnittstelle von dem Anschlusspinmuster (4) der Steuerelektronik (1) zu einem Pinmuster (7) eines kundenseitigen Bordnetzes besitzt, aufweisend die Schritte:
- Bereitstellen sämtlicher notwendiger Anschlusskontakteinrichtungen (5) für alle abzudeckenden Bustypen im Anschlusspinmuster (4) des Platinenlayouts (3);
- Anordnen von Eingangspins (8) des Steckermoduls (6) in einem Eingangspinmuster (9) korrespondierend zu dem Anschlusspinmuster (4) der Steuerelektronikplatine (2), insbesondere korrespondierend zu einem zu kontaktierenden Bustyp;
- Anordnen von Ausgangspins (10) in einem Ausgangspinmuster (11) des Steckermoduls (6) korrespondierend zu dem Pinmuster (7) eines Gegensteckermoduls des kundenseitigen Bordnetzes;
- Überführen des Eingangspinmusters (9) des Steckermoduls (6) in das Ausgangspinmuster (11) des Steckermoduls (6) innerhalb eines Steckermodulgehäuses (13), wobei mehrere Leiterabschnitte (14), die je einendig einen Eingangspin (8) des Steckermoduls (6) bilden und anderendig einen Ausgangspin (10) des Steckermoduls (6) bilden, als Stanzbiegeteile ausgebildet werden, und die Leiterabschnitte (14) wenigstens in einem Bereich zwischen den Eingangspins (8) und den Ausgangspins (10) ein Leiterabschnittbündel (15) bildend umspritzt oder umgossen werden.

2. Verfahren nach Anspruch 1, **dadurch gekennzeichnet, dass** das Leiterabschnittbündel (15) als separates Bauteil ausgebildet wird und in das Steckermodulgehäuse (6) eingesetzt wird.

3. Verfahren nach Anspruch 1, **dadurch gekennzeichnet, dass** die Leiterabschnitte (14) in einem Formwerkzeug für das Steckermodulgehäuse (13) bei der Herstellung des Steckermodulgehäuses (13) durch Umspritzen oder Umgießen gebündelt werden.

4. Verfahren nach einem der vorangegangenen Ansprüche, **dadurch gekennzeichnet, dass** mit dem Anschlusspinmuster (4) des Platinenlayouts (3) wenigstens ein Anschlusspinmuster (4) für wenigstens einen nachfolgend aufgelisteten Bustyp bereitgestellt wird:
- Pulsweitenmodulation
- LIN-Bus (local interconnect network, Sensoren Aktuatoren), insbesondere in der Version 2.2 umfassend UDS (Unified Diagnostic Systems)
- CAN-Bus, insbesondere CAN-FD (CAN-Bus mit flexibler Datenrate)
- Flex-Ray- Bus (Recherche: geplante Bustypen e-Fahrzeuge)
- Ethernet

5. Verfahren nach einem der vorangegangenen Ansprüche, **dadurch gekennzeichnet, dass** eine Kontaktierung der Eingangspins (8) des Steckermoduls (6) mit den jeweils korrespondierenden Anschlusskontakteinrichtungen (5) des Anschlusspinmusters (4) der Steuerelektronikplatine (2) mittels press-fit-Pins, mittels Lötverbindungen und/oder mittels federbelasteter Kontaktelemente erfolgt.

6. Verfahren nach einem der vorangegangenen Ansprüche, **dadurch gekennzeichnet, dass** eine Anpassung einer Pinbelegung des Anschlusspinmusters (4) an das kundenspezifische Bordnetz ausschließlich durch eine angepasste Leiterabschnittführung innerhalb des Steckermoduls (6) erfolgt.

7. Verfahren nach einem der vorangegangenen Ansprüche, **dadurch gekennzeichnet, dass** an das Steckermodul (6) unabhängig von kundenspezifischen Schnittstellengeometrien fluidpumpenseitig ein einheitlicher Steckerkragen (16) zur Befestigung des Steckermoduls (6) an einem variantenübergreifend einheitlichen Abschlussdeckel (17) der Fluidpumpe angeformt wird.

8. Verfahren nach einem der vorangegangenen Ansprüche, **dadurch gekennzeichnet, dass** für die Steuerungselektronik (2) ein Platinenlayout (3) verwendet wird, welches mittels angepasster Bauteilbestückung an unterschiedliche kundenspezifische Anforderungen, zum Beispiel hinsichtlich einer Pumpenleistung, eines verwendeten Bussystems oder dergleichen, angepasst wird.

9. Verfahren nach einem der vorangegangenen Ansprüche **dadurch gekennzeichnet, dass** an einem Antriebsgehäuse oder an dem Abschlussdeckel (17) der Fluidpumpen eine für unterschiedliche Steckermodule (6), insbesondere für deren einheitliche Steckerkragen (16) eine Kundenanforderung unabhängige einheitliche mechanische Aufnahmeschnittstelle bereitgestellt wird.

10. Fluidpumpe aufweisend eine bustypübergreifende Elektronikplattform für die Steuerelektronik (1) geschaffen nach dem Verfahren gemäß einem der Ansprüche 1 bis 9.
